# EUROPEAN PATENT SPECIFICATION

(11) **EP 2 551 926 B1**
(45) Date of publication and mention of the grant of the patent: **08.01.2020**
(21) Application number: 12177931.8
(22) Date of filing: 26.07.2012
(51) Int. Cl.: H01L 33/00, H01L 33/48, H01L 33/54

(54) **Light emitting diode module and method for manufacturing the same**
Lichtemittierendes Diodenmodul und Herstellungsverfahren dafür
Module de diode électroluminescente et son procédé de fabrication

(30) Priority: 26.07.2011 KR 20110074223
(43) Date of publication of application: 30.01.2013
(73) Proprietor: Samsung Electronics Co., Ltd., Suwon-si, Gyeonggi-do, 443-742 (KR)
(72) Inventor: You, Jae Sung, 442-828 Gyeonggi-do (KR)
(74) Representative: Grünecker Patent- und Rechtsanwälte PartG mbB

(56) References cited:
- EP-A2- 2 187 459
- WO-A1-2007/074983
- WO-A2-2006/109113
- WO-A2-2009/072757
- JP-A- 2000 252 524
- US-A1- 2005 280 014
- US-A1- 2006 001 055
- US-A1- 2006 102 918
- US-A1- 2009 278 153
- US-A1- 2011 062 471
- US-B1- 6 392 294

## Description

### BACKGROUND

### 1. Field

The present invention relates to a light emitting diode (LED) module and a manufacturing method for the LED module, and more particularly, to an LED module improved in a lens connection structure and accordingly increased in reliability, and a manufacturing method for the LED module.

### 2. Description of the Related Art

A light emitting diode (LED) refers to a semiconductor device that emits light when a current flows. Due to long lifespan, low power consumption, high response rate, and excellent initial driving characteristics, and the like, the LED is widely applied to various fields including a lighting apparatus, an electric sign, a back light unit of a display device, and the like.

In recent times, the LED is being used as a light source in various colors. With an increase in demands for a high output and high luminance LED, research is being performed actively to increase performance and reliability of an LED package. To increase performance of an LED product, not only an LED having a high optical efficiency but also an LED package efficiently extracting light and having a high color purity and uniform characteristics of products is to be secured.

Factors such as color, light velocity, distribution of light intensity, and the like may determine characteristics of the LED. The characteristics of the LED may be determined primarily, by compound semiconductor materials used for the LED, and secondarily by a phosphor application method and a package structure.

Characteristics of an LED chip as the primary factor have developed rapidly. However, as development is currently slowing down, the development of secondary factors is necessary for improving the light velocity and the light intensity distribution. In addition, high reliability of the LED package is being demanded.

A phosphor is disposed on a blue LED or an ultraviolet (UV) LED to obtain white light using the LED. A white LED may achieve white light by performing partial color conversion of light extracted from the UV or blue LED through combination of red, green, blue, and yellow phosphors, and then mixing the color-converted lights.

The LED may be manufactured in a form of a package or module to be a product. First, an LED package is prepared by mounting an LED chip on a lead frame and a ceramic substrate, mixing and applying a phosphor according to a desired application, and forming a lens. Next, the LED package is cut into unit LED packages and the unit LED package is mounted on a printed circuit board (PCB). Thus, a modularized LED is achieved.

The foregoing modularizing structure in which the LED package is mounted on the PCB is limited in minimizing size of an LED module. As the mounting is performed two times or more, the inferiority rate may increase, thereby reducing a price of the LED module. In addition, deviations may occur in luminance and color of the LED package due to various factors including deviations of luminance and wavelength of the LED, a tolerance in manufacturing a structure such as a lead frame, a tolerance in processing such as phosphor application, lens formation, and the like.

Therefore, to increase uniformity of optical characteristics such as luminance and color of the LED module as a resultant product, LEDs having various luminances and colors are grouped by binning and the respective binned LEDs are combinedly used.

However, when the deviations of luminance and color are great, even by binning of the LEDs, the deviations are not solved. Therefore, binning groups of the LEDs are determined within a range not causing the optical deviation of the LED module. That is, LEDs not included in the determined binning groups are unusable. Accordingly, yield is decreased and a manufacturing cost of producing the LED module is increased.

As a consequence, rather than the package type, a chip-on-board (COB) type module in which the LED is mounted directly on a module substrate is manufactured in recent times. The LED module manufactured in the COB type may reduce the manufacturing cost while increasing heat radiation efficiency by shortening a heat transfer path. However, when a lens is provided to the module substrate, the lens may be separated.

According to US 2005/0280014 A1 an LED module and fabrication method thereof is disclosed, wherein the LED module is provided with a substrate having a cup part housing an LED chip and a lens fastened to the upper portion of the substrate.

According to JP 2000252524 A, an LED module is provided with a substrate having an upper surface with stepped portions at its edges and a lens moulded over the upper surface of the substrate.

According to WO 2007/074983 A1 another LED module is provided with a substrate having a cup part housing an LED chip and a lens fastened to the upper portion of the substrate.

According to US 2009/0278153 an LED module is provided with a substrate, a recess formed in the upper surface of the substrate, an electrode formed on the upper surface and into the recess, an LED chip on the electrode, and a lens fastened to the upper surface.

According to US 2006/0102918 A1 an LED module is provided with a substrate having a cup part housing an LED chip and an upper portion of the substrate includes a plurality of indentations that are filled with a transparent or semi-transparent seal.

According to EP 2 187 459 A2, an LED module is provided with a plurality of lead frame units spaced apart from each other and having a recess in an upper surface, an LED chip on the upper surface, and a transparent seal fastened to the lead frame units via the recess.

According to WO 2006/109113 an LED module is provided with with a substrate, a recess formed in an upper surface of the substrate, an electrode on the upper surface, an LED chip on the electrode, and a lens fastened to the upper surface via the recess.

According to US 2006/0001055 A1 an LED module is provided with a substrate having a recess in an upper surface, an electrode on the upper surface without overlapping the recess, an LED chip on the electrode, and a lens fastened to the upper surface, wherein the recess serves to align the lens during assembly with the substrate.

### SUMMARY

An aspect of the present invention provides a light emitting diode (LED) module having increased reliability by being improved in a lens connection structure as in independent claim 1, and a manufacturing method of the LED module as in independent claim 8. Further embodiments of the invention are provided in the dependent claims.

According to an aspect of the present invention, there is provided an LED module including a substrate formed with a recess in the upper plane surface of the substrate, an electrode directly disposed on the upper plane surface of the substrate, an LED chip directly mounted on the electrode on the substrate, a phosphor layer formed on the LED chip, and a lens directly disposed on the upper plane surface of the substrate and fastened to the substrate through the recess, wherein the lens is fastened to the substrate by filling the recess with a lens forming material, thereby covering the recess, the electrode, the phosphor layer and the LED chip, and wherein the electrode is directly disposed on the upper plane surface of the substrate without overlapping the recess.

A plurality of the recesses may be formed on the substrate.

The plurality of recesses may be extended along edges of the substrate.

The plurality of recesses may be disposed at corners of the substrate.

The plurality of recesses may have identical shapes.

The plurality of recesses may have different shapes.

The plurality of recesses may be provided in a polygonal shape, an L-shape, or a circular shape.

According to another aspect of the present invention, there is provided a manufacturing method for an LED module, including forming a recess in an upper plane surface of a substrate, disposing an electrode directly on the upper plane surface of the substrate, mounting an LED chip directly on the electrode, forming a phosphor layer on the LED chip, and forming a lens directly on the upper plane surface of the substrate such that the lens is fastened to the substrate through the recess, by filling the recess with a lens forming material, thereby covering the recess, the electrode, the phosphor layer and the LED chip, wherein the electrode is disposed directly on the upper plane surface of the substrate without overlapping the recess.

A plurality of the recesses may be formed on the substrate, and the plurality of recesses may be extended along edges of the substrate.

A plurality of the recesses may be formed on the substrate, and the plurality of recesses may be disposed at corners of the substrate.

Additional aspects, features, and/or advantages of example embodiments will be set forth in part in the description, which follows and, in part, will be apparent from the description, or may be learned by practice of the disclosure.

### BRIEF DESCRIPTION OF THE DRAWINGS

These and/or other aspects and advantages will become apparent and more readily appreciated from the following description of the example embodiments, taken in conjunction with the accompanying drawings of which:
FIG. 1 is a perspective view of a light emitting diode (LED) module according to an embodiment of the present invention;
FIG. 2 is a sectional view of the LED module shown in FIG. 1;
FIG. 3 is a perspective view of an LED module according to another embodiment of the present invention;
FIG. 4 is a sectional view of the LED module shown in FIG. 3;
FIGS. 5 and 6 are perspective views of an LED module according to still another embodiment of the present invention; and
FIGS. 7A to 7E are diagrams illustrating a manufacturing method for an LED module according to an embodiment of the present invention.

### DETAILED DESCRIPTION

Reference will now be made in detail to example embodiments, examples of which are illustrated in the accompanying drawings, wherein like reference numerals refer to the like elements throughout. Example embodiments are described below to explain the present disclosure by referring to the figures.

In the description of embodiments, it will be understood that when a layer, a surface, or a portion is referred to as being "on" another layer, a surface, or a portion, it can be directly on the another layer, a surface, or a portion, or intervening layers may also be present. Further, the reference about "on" and "under" each layer will be made on the basis of drawings.

In the drawings, thicknesses or sizes of each element may be exaggerated for convenience in description and clarity. Also, the sizes of each element do not entirely reflect an actual size.

Hereinafter, a camera flash module according to example embodiments will be described in detail with reference to the accompanying drawings.

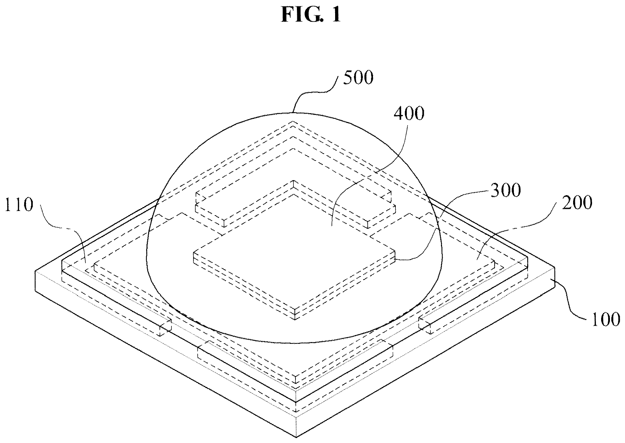

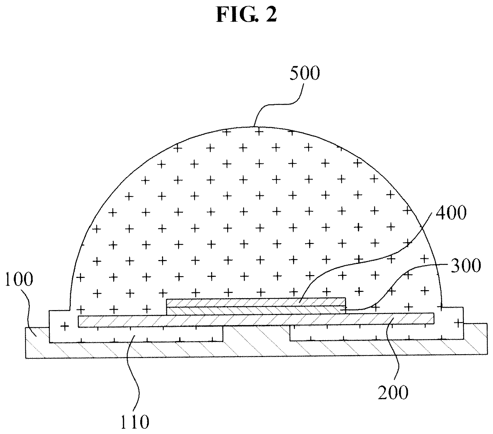

FIG. 1 is a perspective view of a light emitting diode (LED) module according to example embodiments. FIG. 2 is a sectional view of the LED module shown in FIG. 1.

Referring to FIGS. 1 and 2, the LED module includes a substrate 100, an electrode 200, an LED 300, a phosphor layer 400, and a lens 500.

The substrate 100 may be formed of metal, silicone, or ceramic. The substrate 100 may be formed of a material having excellent heat radiation characteristics. The upper plane surface of the substrate 100 includes a recess 110. The recess 110 will be described in further details in relation to a fastening structure of the lens 500.

The electrode 200 is directly disposed on the upper plane surface of the substrate 100. In particular, the electrode 200 is not disposed on the recess 110 formed on the upper plane surface of the substrate 100. That is, the electrode 200 is disposed without overlapping the recess 110. The electrode 200 may apply power to the LED chip 300 and, for this purpose, may include an electrical circuit.

The LED chip 300 is directly mounted on the electrode 200. The LED chip 300 may be mounted by a flip-chip bonding method that uses solder or a conductive adhesive. That is, the LED chip 300 is flip-chip bonded to the electrode 200. Besides the flip-chip bonding, the LED chip 300 may be mounted on the electrode 200 by die bonding.

When the LED module is manufactured by the chip-on-board (COB) method according to an aspect of the present invention, a flip chip on module (FCOM) method may be used in which the LED chip 300 is mounted on the electrode 200 in a flip-chip manner without using the wire bonding for electrical connection between the LED chip 300 and the substrate 100. When the LED chip 300 is mounted in the FCOM method, since the LED chip 300 is mounted in the flip-chip manner, high density mounting of the LED chip 300 may be achieved. Also, module size may be reduced.

The LED 300 chip may be mounted on the electrode 200 using a bump (not shown). The bump (not shown) may be formed of a metallic material or a material having excellent heat radiation characteristics. By forming the substrate 100 and the bump (not shown) of the material having excellent heat radiation characteristics, such as metal, ceramic, and the like, heat radiation characteristics of the LED module may be increased.

The LED chip 300 will be briefly described. The LED chip 300 may include a first conductive type semiconductor layer, an active layer, a second conductive type semiconductor layer, and an electrode. The first conductive type semiconductor layer may be n-doped. Electrons are moved to the active layer through the first conductive type semiconductor layer.

The active layer is disposed on the first conductive type semiconductor layer. The active layer may have a laminated structure including a quantum barrier layer and a quantum well layer alternately deposited, so that electrons and holes recombine, and emit light. Composition of the active layer may be varied according to a desired light emission wavelength.

The second conductive type semiconductor layer may be disposed on the active layer. The second conductive type semiconductor layer may be p-doped. The holes are moved to the active layer through the second conductive type semiconductor layer.

A transparent electrode may be disposed on the second conductive type semiconductor layer. The transparent electrode may be formed as a transparent layer of metal such as nickel (Ni) or gold (Au). Also, the transparent electrode may be made of a conductive oxide such as indium tin oxide (ITO). A p-type electrode is disposed on the transparent electrode. An n-type electrode is disposed on the first conductive type semiconductor layer. The p-type electrode and the n-type electrode may be made of various metals such as titanium (Ti) and aluminum (Al).

The holes are supplied through the p-type electrode while the electrons are supplied through the n-type electrode. Thus-supplied holes and electrons combine at the active layer, thereby generating light energy. An ultraviolet (UV) LED or a blue LED may be achieved according to a wavelength of emitted light.

The phosphor layer 400 is formed on the LED chip 300. Light emitted from the LED chip 300 passes through the phosphor layer 400 and advance toward the lens 500.

The phosphor layer 400 may scatter and thereby color-convert the light emitted from the LED 300. For example, blue light from the LED chip 300 may be converted to yellow, green, or red light by passing through the phosphor layer 400. As a result, white light may be emitted to the outside.

The phosphor layer 400 may include a phosphor adapted to convert blue light to yellow, green, or red light. The phosphor material 400 may include a host material and an active material. For example, the host material may be yttrium aluminum garnet (YAG) and the active material may be cerium. Alternatively, the phosphor material 400 may include a silicate-based host material and europium (Eu) as the active material. However, the materials of the phosphor layer 400 are not specifically limited.

The phosphor layer 400 may have a uniform and small thickness. Phosphor particles may be evenly distributed in the phosphor layer 400. Therefore, the light passed through the phosphor layer 400 may be uniformly color-converted. In addition, since the phosphor layer 400 has a uniform plane surface, the phosphor particles around the LED chip 300 may be uniformly distributed and, additionally, design of an optical system may be facilitated by surface emission.

The light emitted from the LED chip 300 is emitted to the outside through the lens 500 after passing through the phosphor layer 400. An upper portion of the lens 500 may have a refractive surface, which is convex in a direction of emitting incident light. The upper portion of the lens 500 may have a particular radius of curvature to adjust a view angle of the light being emitted to the outside.

The lens 500 is directly formed on the upper plane surface of the substrate 100. That is, the lens 500 is formed by injecting a lens forming material, filling the recess 110, thereby covering the recess 110, the electrode 200, the phosphor layer 400 and the LED chip 300, and fastening the lens 500 to the substrate 100 through the recess 110. The lens 500 may be made of silicone or the like. As aforementioned, the lens 500 is fastened to the substrate 100 using the recess 110 formed in the upper plane surface of the substrate 100.

The recess 110 may be plural in number. In this case, the recesses 110 are disposed without overlapping the electrode 200. Here, the recesses 110 may be formed after the electrode 200 is formed in the upper plane surface of the substrate 100. Alternatively, after the recesses 110 are formed in the upper plane surface of the substrate 100, the electrode 200 may be deposited.

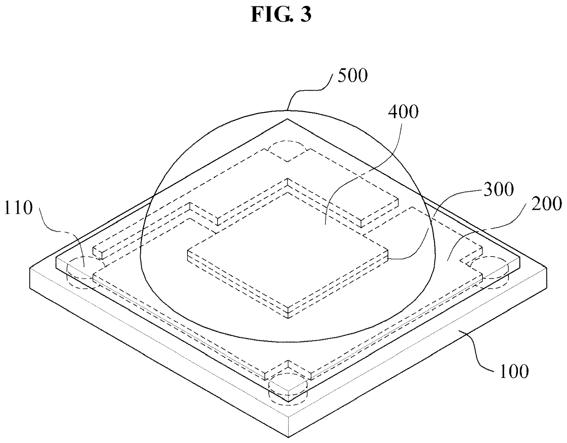

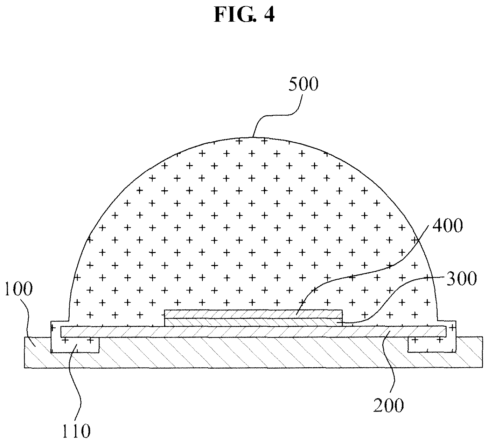

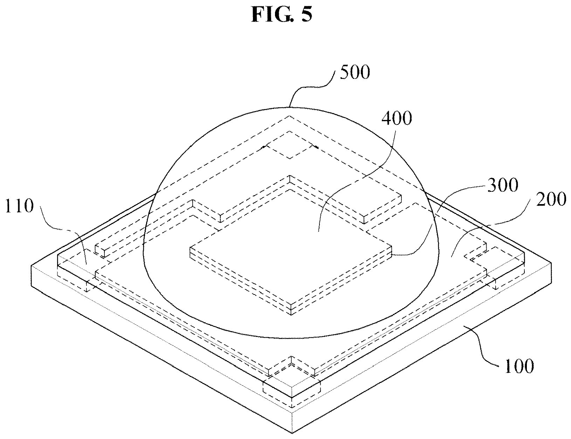

The plurality of recesses 110 may be disposed at corners of the substrate 100. As shown in FIGS. 1 to 5, the plurality of recesses 110 may be formed in various configurations at the corners. That is, the plurality of recesses 110 may be provided in a polygonal shape such as a triangle or a rectangle as shown in FIG. 5, or a circular shape as shown in FIG. 3 or 4. Also, the plurality of recesses 110 may have an L-shape as shown in FIG. 1 or 2, or an inverse L-shape according to a viewpoint. Since the plurality of recesses 110 are provided to fasten the lens 500, any other shape may be applied as long as facilitating the fastening and preventing escape of the lens 500 from the substrate 100.

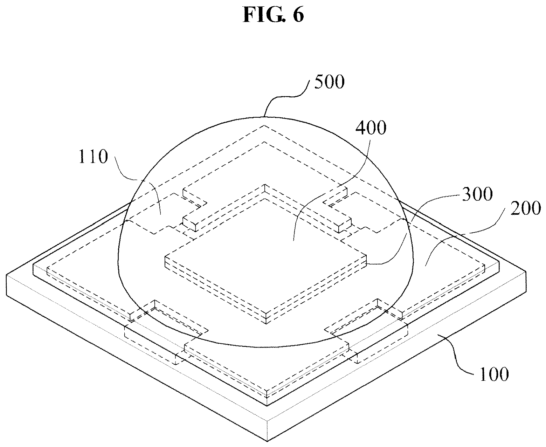

In addition, the plurality of recesses 110 may be disposed along edges of the substrate 100 as shown in FIG. 6. In this case, the plurality of recesses 110 may be provided in various shapes such as a rectangle, a square, and the like.

The plurality of recesses 110 may be provided in identical shapes or different shapes. That is, as long as the lens 500 is securely fastened, the plurality of recesses 110 may have any shape, diameter, depth, and the like. Furthermore, the plurality of recesses 110 may be disposed to prevent overlapping the electrode 200.

Fastening between the lens 500 and the substrate 100 through the recess 110 is performed as the recess 110 is filled with the lens forming material. That is, the lens 500 is formed directly on the upper plane surface of the substrate 100 by injecting the lens forming material in the recess 110.

Hereinafter, a method of manufacturing an LED module according to an embodiment of the present invention will be described.

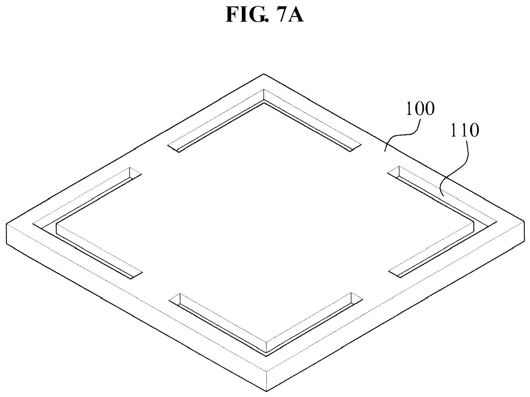

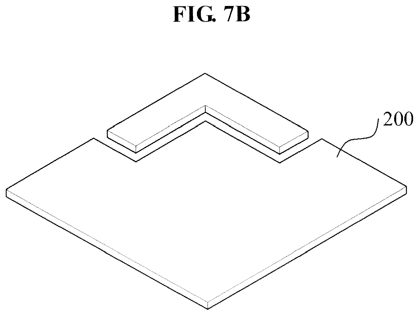

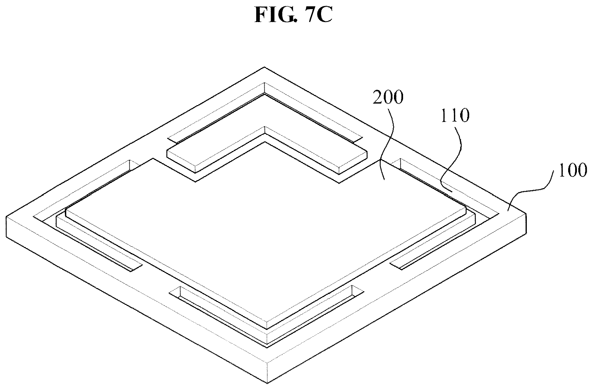

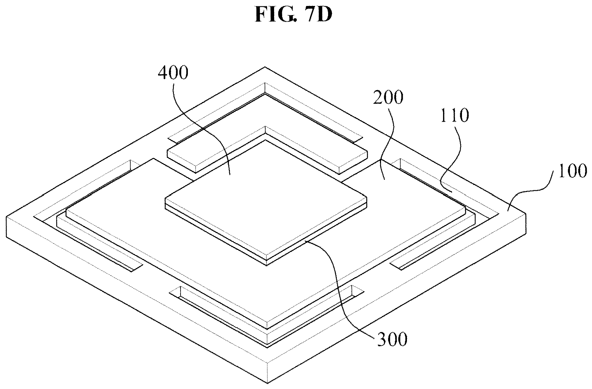

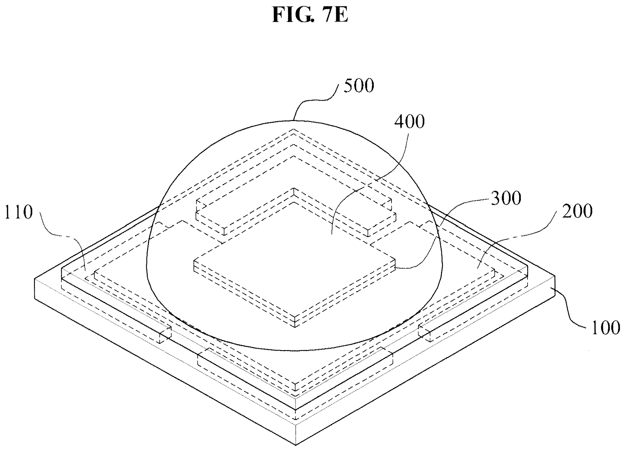

FIGS. 7A to 7E are diagrams illustrating a manufacturing method for an LED module according to an embodiment of the present invention.

The LED module manufacturing method includes forming a recess 110 in an upper plane surface of a substrate 100, disposing an electrode 200 directly on the upper surface of the substrate 100, directly mounting an LED chip 300 on the electrode 200, forming a phosphor layer 400 on the LED chip 300, and forming a lens 500 directly on the upper plane surface of the substrate 100 such that the lens 500 is fastened to the substrate 100 through the recess 110.

First, the substrate 100 formed with the recess 110 is prepared and the electrode 200 is deposited on the substrate 100 without overlapping the recess 110. In another way, after the electrode 200 is deposited on the upper plane surface of the substrate 100 first, the recess 110 is formed without overlapping the electrode 200.

A plurality of the recesses 110 may be provided. The plurality of recesses 110 may be disposed along edges of the substrate 100 or at corners of the substrate 100. Since the arrangement of the recesses 110 is described the foregoing, a detailed description will be omitted for conciseness.

Next, the LED chip 300 is directly mounted on the electrode 200 in various methods. For example, a bump (not shown) or a conductive adhesive (not shown) may be used to mount the LED chip 300.

When the LED module is manufactured by the COB method according to an aspect of the present invention, the FCOM method may be used in which the LED chip 300 is mounted on the electrode 200 in a flip-chip manner without using the wire bonding for electrical connection between the LED chip 300 and the substrate 100. When the LED chip 300 is mounted in the FCOM method, since the LED chip 300 is mounted in the flip-chip manner, high density mounting of the LED chip 300 may be achieved. Also, a module size may be reduced.

Next, the phosphor layer 400 is formed on the LED chip 300. The phosphor layer 400 may be formed to have a uniform and small thickness and to surround an entire part of the LED chip 300. Since the phosphor layer 400 is thin and uniform, the phosphor particles around the LED chip 300 may be uniformly distributed. Additionally, the light emitted from the LED chip 300 may be uniformly color-converted.

After the phosphor layer 400 is formed, the lens 500 is formed directly on the upper plane surface of the substrate 100. The lens 500 may be formed of silicone or the like. Compression molding or transfer molding may be used to form the lens 500 directly on the upper plane surface of the substrate 100.

The compression molding uses a mold and a press that applies heat and pressure. According to the compression molding, a lens forming material is applied on an overall surface of the substrate. Therefore, when electrical connection of the LED module is necessary, the lens forming material may be removed from a position corresponding to the electrical connection.

That is, the mold is disposed on the upper plane surface of the substrate 100 on which the LED chip 300 and the phosphor layer 400 are formed. Next, the lens forming material is injected in the recess in the upper plane surface of the substrate 100 and an overall surface of the mold and then firstly heat-cured. Next, the mold is removed and the lens forming material is secondly heat-cured. The lens forming material may be partially removed from the position corresponding to the electric connection. Thus, the lens 500 is formed.

According to the transfer molding, after the lens forming material is forced into a hermetic heating mold, the lens forming material having plasticity is cured during transfer. The transfer molding is similar to the compression molding but is more appropriate for a complicated shape or a fragile insert that cannot apply general compression molding. In addition, the transfer molding may achieve uniform quality and accurate measure of respective parts of the molded product.

Therefore, in the operation of forming the lens 500 according to the present invention, the lens 500 is fastened to the substrate 100 by filling the recesses 110. That is, during the forming of the lens 500, the lens forming material fills the recesses 110 disposed at corners or along edges of the substrate 100. Accordingly, high adhesion between the substrate 100 and the lens 500 may be achieved without using a dedicated adhesive and the like, thereby simplifying the manufacturing process and reducing the cost.

Since fastening between the substrate 100 and the lens 500 is achieved by filling the recesses 100 with the lens forming material, adhesion between the lens 500 and the substrate 100 may be increased. Also, since a gap is not generated between the lens 500 and the substrate 100, high adhesion may be achieved as if the substrate 100 and the lens 500 were integrally formed.

Thus, according to the present invention, a substrate 100 and a lens 500 are fastened to each other by filling recesses 110 with a lens forming material without a dedicated adhesive. Furthermore, since the lens 500 does not easily escape by an external shock, reliability of the LED module may be increased. Accordingly, escape of the lens 500 from the substrate 100 may be prevented.

Moreover, since the lens 500 is formed directly on the substrate 100 by the COB method, the manufacturing cost may be reduced. In addition, heat radiation efficiency may be increased by shortening a heat transfer path.

Although a few exemplary embodiments of the present invention have been shown and described, the present invention is not limited to the described exemplary embodiments. Instead, it will be appreciated by those skilled in the art that changes may be made to these exemplary embodiments without departing from the scope of the present invention, which is defined by the appended claims.

## Claims

1. A light emitting diode module comprising:
a substrate (100) with an upper plane surface and a recess (110) formed in the upper plane surface;
an electrode (200) directly disposed on the upper plane surface of the substrate (100);
a light emitting diode chip (300) directly mounted on the electrode (200);
a phosphor layer (400) formed on the light emitting diode chip (300); and
a lens (500) directly disposed on the upper plane surface of the substrate (100) and fastened to the substrate (100) through the recess (110);
wherein the lens (500) is fastened to the substrate (100) by filling the recess (110) with a lens forming material, thereby covering the recess (110), the electrode (200), the phosphor layer (400) and the light emitting diode chip (300),
**characterized in that**
the electrode (200) is directly disposed on the upper plane surface of the substrate (100) without overlapping the recess (110).

2. The light emitting diode module of claim 1, wherein a plurality of the recesses (110) are formed in the upper plane surface of the substrate (100).

3. The light emitting diode module of claim 2, wherein the plurality of recesses (110) are extended along edges of the substrate (100).

4. The light emitting diode module of claim 2, wherein the plurality of recesses (110) are disposed at corners of the substrate (100).

5. The light emitting diode module of claim 2, wherein the plurality of recesses (110) are provided in identical shapes.

6. The light emitting diode module of claim 2, wherein the plurality of recesses (110) are provided in different shapes.

7. The light emitting diode module of claim 2, wherein the plurality of recesses (110) are provided in a polygonal shape, an L-shape, or a circular shape.

8. A manufacturing method for a light emitting diode module comprising:
forming a recess (110) in an upper plane surface of a substrate (100);
disposing an electrode (200) directly on the upper plane surface of the substrate (100);
mounting a light emitting diode chip (300) directly on the electrode (200);
forming a phosphor layer (400) on the light emitting diode chip (300); and
forming a lens (500) directly on the upper plane surface of the substrate (100) such that the lens (500) is fastened to the substrate (100) through the recess (110), by filling the recess (110) with a lens forming material, thereby covering the recess (110), the electrode (200), the phosphor layer (400) and the light emitting diode chip (300);
**characterized in**
disposing the electrode (200) directly on the upper plane surface of the substrate (100) without overlapping the recess (110).

9. The manufacturing method of claim 8, wherein
a plurality of the recesses (110) are formed in the upper plane surface of the substrate (100), and
the plurality of recesses (110) are extended along edges of the substrate (100).

10. The manufacturing method of claim 8, wherein
a plurality of recesses (110) are formed in the upper plane surface of the substrate (100), and
the plurality of recesses (110) are disposed at corners of the substrate (100).

## Patentansprüche

1. Ein lichtemittierendes Diodenmodul umfassend:
ein Substrat (100) mit einer oberen ebenen Fläche und einer in der oberen ebenen Fläche gebildeten Aussparung (110);
eine Elektrode (200), direkt auf der oberen ebenen Fläche des Substrats (100) angeordnet;
einen lichtemittierenden Diodenchip (300), direkt auf der Elektrode (200) angebracht;
eine Phosphorschicht (400), auf dem lichtemittierenden Diodenchip (300) gebildet; und
eine Linse (500), direkt auf der oberen ebenen Fläche des Substrats (100) angeordnet und durch die Aussparung (110) am Substrat (100) befestigt;
wobei die Linse (500) am Substrat (100) befestigt wird, indem die Aussparung (110) mit einem linsenbildenden Material befüllt wird, dabei die Aussparung (110), die Elektrode (200), die Phosphorschicht (400) und den lichtemittierenden Diodenchip (300) bedeckend,
**dadurch gekennzeichnet, dass**
die Elektrode (200) direkt auf der oberen ebenen Fläche des Substrats (100) angeordnet ist, ohne die Aussparung (110) zu überdecken.

2. Das lichtemittierende Diodenmodul aus Anspruch 1, wobei eine Vielzahl von Aussparungen (110) in der oberen ebenen Fläche des Substrats (100) gebildet sind.

3. Das lichtemittierende Diodenmodul aus Anspruch 2, wobei die Vielzahl von Aussparungen (110) sich entlang Rändern des Substrats (100) erstrecken.

4. Das lichtemittierende Diodenmodul aus Anspruch 2, wobei die Vielzahl von Aussparungen (110) an Ecken des Substrats (100) angeordnet sind.

5. Das lichtemittierende Diodenmodul aus Anspruch 2, wobei die Vielzahl von Aussparungen (110) in identischen Formen vorgesehen sind.

6. Das lichtemittierende Diodenmodul aus Anspruch 2, wobei die Vielzahl von Aussparungen (110) in unterschiedlichen Formen vorgesehen sind.

7. Das lichtemittierende Diodenmodul aus Anspruch 2, wobei die Vielzahl von Aussparungen (110) in einer polygonalen Form, einer L-Form, oder einer Kreisform vorgesehen sind.

8. Ein Herstellungsverfahren für ein lichtemittierendes Diodenmodul umfassend:
Ausbilden einer Aussparung (110) in einer oberen ebenen Fläche eines Substrats (100);
Anordnen einer Elektrode (200), direkt auf der oberen ebenen Fläche des Substrats (100);
Anbringen eines lichtemittierenden Diodenchips (300), direkt auf der Elektrode (200);
Ausbilden einer Phosphorschicht (400) auf dem lichtemittierenden Diodenchip (300); und
Ausbilden einer Linse (500) direkt auf der oberen ebenen Fläche des Substrats (100), so dass die Linse (500) am Substrat (100) durch die Aussparung (110) befestigt wird, indem die Aussparung (110) mit einem linsenbildenden Material befüllt wird, dabei die Aussparung (110), die Elektrode (200), die Phosphorschicht (400) und den lichtemittierenden Diodenchip (300) bedeckend;
**gekennzeichnet durch**
Anordnen der Elektrode (200), direkt auf der oberen ebenen Fläche des Substrats (100), ohne die Aussparung (110) zu überdecken.

9. Das Herstellungsverfahren aus Anspruch 8, wobei
eine Vielzahl von Aussparungen (110) in der oberen ebenen Fläche des Substrats (100) gebildet sind, und
die Vielzahl von Aussparungen (110) sich entlang Rändern des Substrats (100) erstrecken.

10. Das Herstellungsverfahren aus Anspruch 8, wobei
eine Vielzahl von Aussparungen (110) in der oberen ebenen Fläche des Substrats (100) gebildet sind, und
die Vielzahl von Aussparungen (110) an Ecken des Substrats (100) angeordnet sind.

## Revendications

1. Module de diode électroluminescente comprenant :
un substrat (100) présentant une surface plane supérieure et une cavité (110) formée dans la surface plane supérieure ;
une électrode (200) directement disposée sur la surface plane supérieure du substrat (100) ;
une puce de diode électroluminescente (300) montée directement sur l'électrode (200) ;
une couche de phosphore (400) formée sur la puce de diode électroluminescente (300) ; et
une lentille (500) disposée directement sur la surface plane supérieure du substrat (100) et fixée au substrat (100) par le biais de la cavité (110) ;
dans lequel la lentille (500) est fixée au substrat (100) en remplissant la cavité (110) d'un matériau formant la lentille, couvrant ainsi la cavité (110), l'électrode (200), la couche de phosphore (400) et la puce de diode électroluminescente (300),
**caractérisé en ce que**
l'électrode (200) est directement disposée sur la surface plane supérieure du substrat (100) sans chevauchement de la cavité (110) ;

2. Le module de diode électroluminescente de la revendication 1, dans lequel une pluralité de cavités (110) est constituée dans la surface plane supérieure du substrat (100).

3. Le module de diode électroluminescente de la revendication 2, dans lequel la pluralité de cavités (110) est étendue le long d'arêtes du substrat (100).

4. Le module de diode électroluminescente de la revendication 2, dans lequel la pluralité de cavités (110) est disposée à des coins du substrat (100).

5. Le module de diode électroluminescente de la revendication 2, dans lequel la pluralité de cavités (110) est fournie dans des formes identiques.

6. Le module de diode électroluminescente de la revendication 2, dans lequel la pluralité de cavités (110) est fournie dans différentes formes.

7. Le module de diode électroluminescente de la revendication 2, dans lequel la pluralité de cavités (110) est fournie dans une forme polygonale, une forme de L ou une forme circulaire.

8. Procédé de fabrication pour un module de diode électroluminescente comprenant :
formation d'une cavité (110) dans une surface plane supérieure d'un substrat (100) ;
disposition d'une électrode (200) directement sur la surface plane supérieure du substrat (100) ;
montage d'une puce de diode électroluminescente (300) directement sur l'électrode (200) ;
formation d'une couche de phosphore (400) sur la puce de diode électroluminescente (300) ; et
formation d'une lentille (500) directement sur la surface plane supérieur du substrat (100) de sorte que la lentille (500) soit fixée au substrat (100) en remplissant la cavité (110) d'un matériau formant la lentille, couvrant ainsi la cavité (110), l'électrode (200), la couche de phosphore (400) et la puce de diode électroluminescente (300) ;
**caractérisé en**
disposant l'électrode (200) directement sur la surface plane supérieure du substrat (100) sans chevauchement de la cavité (110).

9. Le procédé de fabrication de la revendication 8, dans lequel
une pluralité des cavités (110) est constituée dans la surface plane supérieure du substrat (100), et
la pluralité de cavités (110) est étendue le long d'arêtes du substrat (100).

10. Le procédé de fabrication de la revendication 8, dans lequel
une pluralité de cavités (110) est constituée dans la surface plane supérieure du substrat (100), et
la pluralité de cavités (110) est disposée à des coins du substrat (100).
